# EUROPÄISCHE PATENTSCHRIFT

(11) **EP 3 053 176 B1**
(45) Veröffentlichungstag und Bekanntmachung des Hinweises auf die Patenterteilung: **12.12.2018**
(21) Anmeldenummer: 14783786.8
(22) Anmeldetag: 01.10.2014
(51) Int. Cl.: H01H 9/16, E05F 15/00

(54) **VERFAHREN UND VORRICHTUNG ZUM ÜBERWACHEN ZUMINDEST EINES ELEKTRONISCHEN SCHALTKONTAKTS FÜR EIN FAHRZEUG**
METHOD AND APPARATUS FOR MONITORING AT LEAST ONE ELECTRONIC SWITCHING CONTACT FOR A VEHICLE
PROCÉDÉ ET DISPOSITIF DE SURVEILLANCE D'AU MOINS UN CONTACT DE COMMANDE POUR UN VÉHICULE

(30) Priorität: 02.10.2013 DE 102013110993
(43) Veröffentlichungstag der Anmeldung: 10.08.2016
(73) Patentinhaber: Knorr-Bremse Gesellschaft mit beschränkter Haftung, 2340 Mödling (AT)
(72) Erfinder: MAIR, Andreas, A-4554 Oberschlierbach (AT); BERNECKER, Günther, A-4611 Buchkirchen (AT)
(74) Vertreter: Aurigium Leischner & Luthe
(86) Internationale Anmeldenummer: PCT/EP2014/071023
(87) Internationale Veröffentlichungsnummer: WO 2015/049276

(56) Entgegenhaltungen:
- EP-A1- 0 681 310
- DE-A1-102011 003 279
- DE-A1-102011 105 112
- FR-A1- 2 807 193
- US-A- 5 119 739
- US-A1- 2008 036 578
- US-B1- 8 269 376

## Beschreibung

Die vorliegende Erfindung bezieht sich auf ein Verfahren und eine Vorrichtung zum Überwachen zumindest eines elektronischen Schaltkontakts, beispielsweise für ein Türsystem für ein Fahrzeug und auf eine Schaltung für ein eine Mehrzahl von Elementen, beispielsweise Türen umfassendes System für ein Fahrzeug.

Mit einer Zustandsüberwachung eines (elektrischen) Schalters können zumindest die Zustände oder Stellungen "Schalter offen" und "Schalter geschlossen" überwacht werden. Bei einem 4-poligen mechanisch zwangsgeführten Schalter können je zwei Pole einem Schaltkontakt zugeordnet sein, es gibt somit einen Öffner und einen Schließer oder zwei Öffner und zwei Schließer. Die zwei Schaltkontakte können voneinander galvanisch getrennt aber mittels einer mechanischen Verbindung fest miteinander gekoppelt sein. Dabei kann ein Schaltkontakt im Hauptstromkreis integriert sein und der zweite zwangsgeführte Schaltkontakt als Überwachungskontakt des Hauptstromkontaktes dienen. D. h. der zweite Kontakt dient als Überwachung des ersten Kontakts.

US 8 269 376 B1 offenbart eine Überwachung einer Schalterstellung eines drei Anschlüsse aufweisenden Schalters mittels eines Statussensors. Dabei werden Signale von einer Anschlussseite des Schalters eingelesen. FR 2 807193 A1 offenbart eine elektrische Schaltung zur Informationsübertragung. EP 0 681 310 A1 offenbart eine Schaltung zur Erkennung eines Schaltelements zum Steuern einer Leistungsversorgung einer Last. DE 10 2011 003 279 A1 offenbart ein Verfahren zum Überwachen eines elektronischen Schaltkontakts gemäß dem Oberbegriff von Anspruch 1.

Es ist die Aufgabe der vorliegenden Erfindung ein verbessertes Verfahren und eine verbesserte Vorrichtung zum Überwachen zumindest eines elektronischen Schaltkontakts für ein Fahrzeug und eine verbesserte Schaltung für ein eine Mehrzahl von Elementen umfassendes System für ein Fahrzeug zu schaffen.

Diese Aufgabe wird durch Verfahren und eine Vorrichtung zum Überwachen zumindest eines elektronischen Schaltkontakts für ein Fahrzeug und durch eine Schaltung für ein eine Mehrzahl von Elementen umfassendes System für ein Fahrzeug gemäß den Hauptansprüchen gelöst.

Durch eine elektronische Schalterzustandsüberwachung kann beispielsweise ein zweipoliger Schalter zum Durchschalten oder Unterbrechen einer elektrischen Leitung zuverlässig überwacht werden. Ein solcher Schalter kann in einer elektrischen Schaltung für ein beliebiges Einsatzgebiet, beispielsweise für eine Maschinensteuerung oder für ein beliebiges Einsatzgebiet, beispielsweise für eine Maschinensteuerung oder Systemsteuerung eingesetzt werden. Beispielsweise kann ein solcher Schalter zur Überwachung eines Schließzustands einer Tür eines Türsystems verwendet werden. Andere Anwendungsgebiete können beispielsweise ein Tritt oder eine Trittstufe, einer Verriegelung, eine Bremseinheit oder eine Verriegelungseinheit eines Fahrzeugs umfassen.

Im Unterschied zu einem 4-poligen zwangsgeführten Schalter, dessen mechanische Kopplung seiner zwei Kontakte einen Mindestbetätigungshub benötigt, kann bei einer elektronischen Schalterzustandsüberwachung auf einen solchen Mindestbetätigungshub verzichtet werden. Zudem besteht keine Begrenzung der maximalen Betätigungsgeschwindigkeit. Vorteilhafterweise kann unter Verwendung einer elektronischen Schalterzustandsüberwachung für jede Applikation die geeignetste Schaltervariante eingesetzt werden. Insbesondere kann im Unterschied zu einem 4-poligen zwangsgeführten Schalter auf einen zweiten Kontakt verzichtet werden, wodurch sich der Wegfall eines zweiten (Überwachungs-)Kontakts ergibt. Dadurch, dass Standardschalter verwendbar sind, kann eine Kostenreduktion und eine Bauraumoptimierung erreicht werden. Zudem sind geringere Schaltwege und eine freie Wahl der Betätigungsgeschwindigkeiten realisierbar. Die elektronische Schalterzustandsüberwachung ermöglicht beispielsweise eine Kabelbrucherkennung, eine Schaltkontaktüberwachung sowie eine Verschleißerkennung des Kontaktes.

Ein Verfahren zum Überwachen zumindest eines elektronischen Schaltkontakts für ein Fahrzeug, wobei der Schaltkontakt einen ersten Anschluss für eine erste elektrische Leitung und einen zweiten Anschluss für eine zweite elektrische Leitung aufweist, umfasst die folgenden Schritte:
Einlesen eines ersten Signals von einem mit dem ersten Anschluss verbundenen ersten Überwachungspunkt, um ein erstes Überwachungssignal zu erhalten;
Einlesen eines zweiten Signals von einem mit dem zweiten Anschluss verbundenen zweiten Überwachungspunkt, um ein zweites Überwachungssignal zu erhalten; und
Kombinieren des ersten Überwachungssignals und des zweiten Überwachungssignals, um zumindest einen Zustand des zumindest einen Schaltkontakts zu bestimmen.

Unter einem elektronischen Schaltkontakt kann ein Schalter verstanden werden, durch den zwei elektrische Anschlüsse des Schaltkontakts je nach Schaltzustand des Schaltkontakts entweder elektrisch leitend miteinander verbunden sind oder voneinander elektrisch isoliert sind. Somit kann der Schaltkontakt zum gesteuerten Unterbrechen einer Leitung eingesetzt werden. Der Zustand des Schaltkontakts kann durch Ausführen der Schritte des Verfahrens überwacht werden. Der Zustand kann beispielsweise angeben, ob der Schaltkontakt geöffnet oder geschlossen ist, welchen Widerstand oder welche Impedanz der Schaltkontakt aufweist oder welche Charakteristik oder Signalform ein den Schaltkontakt durchlaufendes Signal aufweist.

Lediglich beispielhaft kann der Schaltkontakt Teil eines Türsystems für ein Fahrzeug sein. Ein solches Fahrzeug kann beispielsweise ein Schienenfahrzeug sein. Der Schaltkontakt kann in einer sogenannten Grünschleife angeordnet sein, durch die ein Schließzustand der Türen des Fahrzeugs überwacht werden kann.

Der erste und der zweite Überwachungspunkt können auf gegenüberliegenden Seiten des Schaltkontakts angeordnet sein. Unter einem Überwachungspunkt kann ein elektrischer Kontakt oder eine Koppeleinrichtung verstanden werden. Der Überwachungspunkt kann beispielsweise direkt an einem Anschluss des Schaltkontakts oder im Verlauf einer mit dem Anschluss verbundenen Leitung angeordnet sein. Unter einem Signal kann ein elektrischer Strom oder eine elektrische Spannung verstanden werden. Das Signal kann ein Gleichstrom sein, der von einem Störsignal überlagert ist. Das Signal kann von dem Überwachungspunkt abgegriffen werden. Ein entsprechendes Überwachungssignal kann dem eingelesenen Signal entsprechen oder das eingelesene Signal abbilden. Beispielsweise kann das Überwachungssignal eine Wertefolge umfassen, die durch Abtasten des Signals ermittelt werden kann. Wenn der Überwachungspunkt als eine Koppeleinrichtung ausgeführt ist, die eine galvanische Trennung ermöglicht, so kann das Überwachungssignal potenzialfrei von den Anschlüssen des Schaltkontakts oder von mit den Anschlüssen des Schaltkontakts verbundenen Leitungen abgegriffen werden.

Das Kombinieren der Überwachungssignale kann unter Verwendung einer geeigneten Kombiniervorschrift durchgeführt werden. Beispielsweise können die beiden Überwachungssignale durch das Kombinieren miteinander verglichen werden. Der Zustand kann durch Auswerten eines Ergebnisses des Kombinierens bestimmt werden.

Beispielsweise können im Schritt des Kombinierens das erste Überwachungssignal und das zweite Überwachungssignal auf Ähnlichkeit untersucht werden, um den zumindest einen Zustand des zumindest einen Schaltkontakts zu bestimmen. Es können zumindest zwei Ähnlichkeitsgrade definiert sein. Je nachdem ob die Untersuchung auf Ähnlichkeit ergibt, dass der erste oder der zweite Ähnlichkeitsgrad vorliegt, kann entweder ein erster oder ein zweiter Zustand des Schaltkontakts bestimmt werden. Beispielsweise kann ein geschlossener Zustand des Schaltkontakts bestimmt werden, wenn ein hoher Ähnlichkeitsgrad besteht und ein offener Zustand des Schaltkontakts bestimmt werden, wenn ein niedriger Ähnlichkeitsgrad besteht. Auf diese Weise kann ein relevanter Zustand des Schaltkontakts zuverlässig bestimmt werden.

Gemäß einer Ausführungsform können im Schritt des Kombinierens das erste Überwachungssignal und das zweite Überwachungssignal miteinander korreliert werden, um den zumindest einen Zustand des zumindest einen Schaltkontakts zu bestimmen. Durch eine Korrelation lassen sich auch Überwachungssignale mit zeitlich veränderlicher Signalform vergleichen. So können beispielsweise hochfrequente Störsignale, die in den Überwachungssignalen abgebildet sind, zur Bestimmung des Zustands verwendet werden. Solche Störsignale sind aufgrund elektromagnetischer Felder im Umfeld des Schaltkontakts typischerweise immer vorhanden.

Im Schritt des Einlesens des ersten Signals kann das erste Signal von einem ersten Kontakt des ersten Überwachungspunkts eingelesen werden. Dabei kann ein zweiter Kontakt des ersten Überwachungspunkts mit dem ersten Anschluss verbunden sein und der erste und der zweite Kontakt des ersten Überwachungspunkts können galvanisch voneinander getrennt sein. Im Schritt des Einlesens des zweiten Signals kann das zweite Signal von einem ersten Kontakt des zweiten Überwachungspunkts eingelesen werden. Dabei kann ein zweiter Kontakt des zweiten Überwachungspunkts mit dem zweiten Anschluss verbunden sein und der erste und der zweite Kontakt des zweiten Überwachungspunkts können galvanisch voneinander getrennt sein. Ein solcher Überwachungspunkt kann beispielsweise als ein Kondensator ausgeführt sein. Auf diese Weise kann ein Schaltkontakt überwacht werden, der sich in einer von der Umgebung galvanischisch getrennten Schleife, beispielsweise einer Grünschleife befindet.

Gemäß einer Ausführungsform kann das Verfahren einen Schritt des Anlegens eines Diagnosesignals an den ersten Anschluss und/oder den zweiten Anschluss abhängig von dem im Schritt des Kombinierens bestimmten zumindest einen Zustand des Schaltkontakts umfassen. Dabei können die Schritte des Einlesens und Kombinierens ansprechend auf den Schritt des Anlegens erneut durchgeführt werden. Über das Diagnosesignal kann beispielsweise eine Wechselspannung an den Schaltkontakt angelegt werden. Das Diagnosesignal kann eine Signalform aufweisen, die sich von typischerweise an dem Schaltkontakt anliegenden Signalformen unterscheidet. Das Diagnosesignal kann verwendet werden, um den Zustand erneut zu bestimmen oder einen weiteren Zustand des Schaltkontakts zu bestimmen.

Verfahren gemäß einem der vorangegangenen Ansprüche, bei dem im Schritt des Kombinierens als der zumindest eine Zustand ein Schaltzustand des zumindest einen Schaltkontakts bestimmt wird. Beispielsweise kann auf diese Weise zwischen einem geöffneten Zustand und einem geschlossenen Zustand des Schaltkontakts unterschieden werden.

Entsprechend kann im Schritt des Kombinierens als der zumindest eine Zustand ein elektrischer Widerstand des Schaltkontakts und zusätzlich oder alternativ eine Impedanz des Schaltkontakts bestimmt werden. Dadurch kann beispielsweise ein Verschleißzustand des Schaltkontakts bestimmt werden. Entsprechend kann ein elektrischer Widerstand zwischen einem galvanischen Potenzial des Schaltkontakts und einem weiteren galvanischen Potenzial als der Zustand bestimmt werden. Dadurch kann beispielsweise ein Leckstrom erkannt werden.

Entsprechend kann im Schritt des Kombinierens als der zumindest eine Zustand eine Charakteristik eines an dem ersten Anschluss oder dem zweiten Anschluss anliegenden Störsignals bestimmt werden. Auf diese Weise kann beispielsweise das Vorhandensein eines Störfeldes erkannt werden.

Gemäß einer Ausführungsform kann das Verfahren einen Schritt des Einlesens eines dritten Signals von einem dritten Überwachungspunkt umfassen. Der dritte Überwachungspunkt kann mit einem Anschluss eines in Reihe mit dem Schaltkontakt geschalteten weiteren Schaltkontakts verbunden sein, um ein drittes

Überwachungssignal zu erhalten. Dabei können im Schritt des Kombinierens das dritte Überwachungssignal und entweder das erste Überwachungssignal oder das zweite Überwachungssignal oder ein weiteres Überwachungssignal kombiniert werden, um zumindest einen Zustand des weiteren Schaltkontakts zu bestimmen. Das weitere Überwachungssignal kann verwendet werden, wenn in einer Verbindungsleitung zwischen den beiden Schaltkontakten zwei Überwachungspunkte angeordnet sind. Entsprechend können weitere Schaltkontakte unter Verwendung weiterer Überwachungssignale überwacht werden.

Eine Vorrichtung zum Überwachen zumindest eines elektronischen Schaltkontakts für ein Fahrzeug, wobei der Schaltkontakt einen ersten Anschluss für eine erste elektrische Leitung und einen zweiten Anschluss für eine zweite elektrische Leitung aufweist, weist die folgenden Merkmale auf:
eine erste Einleseeinrichtung zum Einlesen eines ersten Signals von einem mit dem ersten Anschluss verbundenen ersten Überwachungspunkt, um ein erstes Überwachungssignal zu erhalten;
eine zweite Einleseeinrichtung zum Einlesen eines zweiten Signals von einem mit dem zweiten Anschluss verbundenen zweiten Überwachungspunkt, um ein zweites Überwachungssignal zu erhalten; und
eine Kombiniereinrichtung zum Kombinieren des ersten Überwachungssignals und des zweiten Überwachungssignals, um zumindest einen Zustand des Schaltkontakts zu bestimmen.

Unter einer Vorrichtung kann ein elektrisches Gerät oder eine elektrische Schaltung, beispielsweise eine integrierte Schaltung verstanden werden. Die Vorrichtung kann ausgebildet sein, um über geeignete Schnittstellen Signale zu empfangen und auszugeben.

Eine Schaltung für ein eine Mehrzahl von Elementen umfassendes System für ein Fahrzeug weist die folgenden Merkmale auf:
eine Reihenschaltung aus einer Mehrzahl von elektronischen Schaltkontakten, wobei je ein Schaltkontakt einem der Elemente zugeordnet ist, und jeder der Schaltkontakte eine Koppelschnittstelle zu einem dem Schaltkontakt zugeordneten Element aufweist, um einen Schließzustand des zugeordneten Elements durch einen Schaltzustand des Schaltkontakts abzubilden;
eine Mehrzahl von Überwachungspunkten, die in der Reihenschaltung angeordnet sind, wobei jedem Anschluss der Schaltkontakte ein Überwachungspunkt zugeordnet ist; und
eine Vorrichtung zum Überwachen der Mehrzahl von Schaltkontakten, wobei die Vorrichtung eine der Mehrzahl von Überwachungspunkten entsprechende Anzahl von Einleseeinrichtungen aufweist, die je mit einem der Überwachungspunkte verbunden und ausgebildet sind, um je ein Signal von einem der Überwachungspunkte einzulesen, um pro Überwachungspunkt ein Überwachungssignal zu erhalten, und wobei die Vorrichtung eine Kombiniereinrichtung aufweist, die ausgebildet ist, um die Überwachungssignale zu kombinieren, um zumindest einen Zustand eines jeden der Schaltkontakte zu bestimmen.

Die Schaltkontakte können beispielsweise Teil einer sogenannten Grünschleife sein. Durch die Vorrichtung zum Überwachen können die Schaltkontakte beispielsweise auf Fehler überprüft werden. Bei dem System kann es sich um ein Zusteigsystem, beispielsweise um ein Türsystem, ein Trittsystem oder eine Verriegelungseinheit, oder um ein Antriebssystem beispielsweise ein Bremssystem des Fahrzeugs handeln. Entsprechend kann es sich bei einem Element, beispielsweise um eine Tür, einen Tritt, einen Verriegelungsmechanismus oder eine Bremseinheit handeln.

Gemäß einer Ausführungsform kann ein erstes Ende der Reihenschaltung als eine Schnittstelle zu einer Energieversorgung ausgeführt sein. Die Reihenschaltung kann an einem dem ersten Ende gegenüberliegenden zweiten Ende einen elektromagnetischen Schalter aufweisen. Die Schaltung kann zumindest einen weiteren Überwachungspunkt aufweisen, der zumindest einem Anschluss des elektromagnetischen Schalters zugeordnet ist und zumindest eine mit dem zumindest einen weiteren Überwachungspunkt verbundene weitere Einleseeinrichtung aufweisen, die ausgebildet ist, um ein Signal von dem zumindest einen weiteren Überwachungspunkt einzulesen, um zumindest ein weiteres Überwachungssignal zu erhalten. Die Kombiniereinrichtung kann ausgebildet sein, um unter Verwendung des weiteren Überwachungssignal als zumindest einen Zustand des elektromagnetischen Schalters ein kapazitives oder induktives Verhalten des in der Reihenschaltung angeordneten elektromagnetischen Schalters zu bestimmen. Bei dem elektromagnetischen Schalter kann es sich beispielsweise um ein Schütz handeln. Der Zustand kann beispielsweise anzeigen, dass der elektromagnetische Schalter einen Defekt aufweist. Alternativ kann der Zustand beispielsweise anzeigen, dass der elektromagnetische Schalter einsatzbereit ist.

Bevorzugte Ausführungsbeispiele der vorliegenden Erfindung werden nachfolgend Bezug nehmend auf die beiliegenden Zeichnungen näher erläutert. Es zeigen:
- Fig. 1: eine schematische Darstellung eines Fahrzeugs gemäß einem Ausführungsbeispiel der vorliegenden Erfindung; und
- Fig. 2: eine schematische Darstellung einer Vorrichtung zum Überwachen eines Schaltkontaktes gemäß einem Ausführungsbeispiel der vorliegenden Erfindung;
- Fig. 3: ein Ablaufdiagramm eines Verfahrens zum Überwachen eines Schaltkontaktes gemäß einem Ausführungsbeispiel der vorliegenden Erfindung;
- Fig. 4: eine Schaltung für ein eine Mehrzahl von Türen umfassendes Türsystem gemäß einem Ausführungsbeispiel der vorliegenden Erfindung;
- Fig. 5: ein Blockdiagramm einer elektronischen Schaltkontaktüberwachung gemäß einem Ausführungsbeispiel der vorliegenden Erfindung; und
- Fig. 6: eine Darstellung von EMV-Zulasssungsgrenzen gemäß einem Ausführungsbeispiel der vorliegenden Erfindung.

In der nachfolgenden Beschreibung der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei eine wiederholte Beschreibung dieser Elemente weggelassen wird.

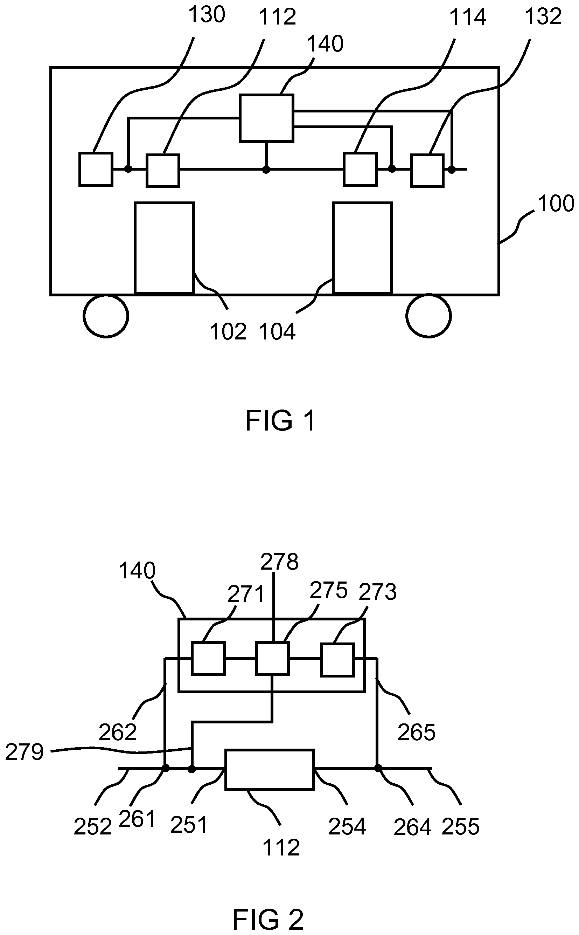

Fig. 1 zeigt eine schematische Darstellung eines Fahrzeugs 100 gemäß einem Ausführungsbeispiel der vorliegenden Erfindung. Bei dem Fahrzeug 100 kann es sich beispielsweise um ein Schienenfahrzeug handeln. Das Fahrzeug 100 weist zwei Türen 102, 104 auf. Jeder Tür 102, 104 ist ein eigener Schaltkontakt 112, 114, auch Schalter genannt, zugeordnet. Der erste Schaltkontakt 112 ist der ersten Tür 102 und der zweite Schaltkontakt 114 ist der zweiten Tür 104 zugeordnet. Der erste Schaltkontakt 112 ist mechanisch mit der ersten Tür 102 gekoppelt. Wenn die erste Tür 102 geöffnet, oder nicht vollständig geschlossen ist, ist der erste Schaltkontakt 112 geöffnet. Dies kann entsprechend bei dem ersten Schaltkontakt 112 und den weiteren Schaltkontakten 114 auch invers sein. Wenn die erste Tür 102 geschlossen ist, ist der erste Schaltkontakt 112 geschlossen. Der zweite Schaltkontakt 114 ist mechanisch mit der zweiten Tür 104 gekoppelt. Wenn die zweite Tür 104 geöffnet, oder nicht vollständig geschlossen ist, ist der zweite Schaltkontakt 114 geöffnet. Wenn die zweite Tür 104 geschlossen ist, ist der zweite Schaltkontakt 114 geschlossen. In einem geschlossen Zustand der Schaltkontakte 112, 114 ist ein Stromfluss durch die Schaltkontakte 112, 114 möglich.

Die Schaltkontakte 112, 114 sind in einer Reihenschaltung verschaltet. An einem Ende der Reihenschaltung wird über eine Energieversorgung 130, beispielsweise in Form einer Spannungsquelle, ein Signal in die Reihenschaltung eingespeist. Bei dem Signal kann es sich beispielsweise um einen Gleichstrom handeln, der durch die Schaltkontakte 112, 114 fließt, wenn die Schaltkontakte 112, 114 alle geschlossen sind. Ist einer der Schaltkontakte 112, 114 geöffnet, so ist der Stromfluss durch die Reihenschaltung unerbrochen. Anhand des Stromflusses kann somit erkannt werden, dass alle Türen 102, 104 geschlossen sind oder dass zumindest eine der Türen 102, 104 geöffnet ist.

Eine Vorrichtung 140 zum Überwachen der Schaltkontakte 112, 114 ist über Überwachungsleitungen mit den Anschlüssen der Schaltkontakte 112, 114 und gemäß einem Ausführungsbeispiel mit den Anschlüssen des Schützes 132 verbunden. Die Vorrichtung 140 ist ausgebildet, um Zustände der Schaltkontakte 112, 114 und gemäß einem Ausführungsbeispiel des Schützes 132 zu überwachen.

Das Ausführungsbeispiel eines Türsystems ist beispielhaft gewählt. Anstelle von Türen 102, 104 können auch andere Elemente des Fahrzeugs 100 unter Verwendung der Schaltkontakte 112, 114 überwacht werden. Die Schaltkontakte 112, 114 können in einer sogenannten Grünschleife angeordnet sein.

Fig. 2 zeigt eine schematische Darstellung einer Vorrichtung 140 zum Überwachen eines Schaltkontaktes 112 gemäß einem Ausführungsbeispiel der vorliegenden Erfindung. Dabei kann es sich um die in Fig. 1 gezeigte Vorrichtung handeln. Bei dem Schaltkontakt 112 kann es sich um einen der in Fig. 1 gezeigten Schaltkontakte handeln.

Der Schaltkontakt 112 weist einen ersten Anschluss 251 auf, der mit einer ersten Leitung 252 verbunden ist. Ferner weist der Schaltkontakt 112 einen zweiten Anschluss 254 auf, der mit einer zweiten Leitung 255 verbunden ist. Aufseiten des ersten Anschlusses 251, beispielsweise an dem ersten Anschluss 251 oder an der ersten Leitung 252 ist ein erster Überwachungspunkt 261 angeordnet, der über eine erste Überwachungsleitung 262 mit der Vorrichtung 140 verbunden ist. Aufseiten des zweiten Anschlusses 254, beispielsweise an dem zweiten Anschluss 254 oder an der zweiten Leitung 255 ist ein zweiter Überwachungspunkt 264 angeordnet, der über eine zweite Überwachungsleitung 265 mit der Vorrichtung 140 verbunden ist.

Die Vorrichtung 140 weist eine erste Einleseeinrichtung 271, eine zweite Einleseeinrichtung 273 und eine Kombiniereinrichtung 275 auf. Die erste Einleseeinrichtung 271 ist ausgebildet, um über die erste Überwachungsleitung 262 und den ersten Überwachungspunkt 261 ein an dem ersten Anschluss 251 oder der ersten Leitung 252 anliegendes Signal einzulesen und als ein erstes Überwachungssignal an die Kombiniereinrichtung 275 auszugeben. Die zweite Einleseeinrichtung 273 ist ausgebildet, um über die zweite Überwachungsleitung 265 und den zweiten Überwachungspunkt 264 ein an dem zweiten Anschluss 254 oder der zweiten Leitung 255 anliegendes Signal einzulesen und als ein zweites Überwachungssignal an die Kombiniereinrichtung 275 auszugeben. Die Kombiniereinrichtung 275 ist ausgebildet, um das erste Überwachungssignal und das zweite Überwachungssignal miteinander zu kombinieren, beispielsweise miteinander zu vergleichen oder zu korrelieren, um zumindest einen Zustand des Schaltkontakts 112 zu bestimmen. Beispielsweise kann die Kombiniereinrichtung 275 ausgebildet sein, um die beiden Überwachungssignale zu kombinieren, um einen eine Ähnlichkeit zwischen den Überwachungssignalen darstellenden Ähnlichkeitswert zu bestimmen. Liegt eine hohe Ähnlichkeit vor, kann der Zustand des Schaltkontakts 112 beispielsweise als geschlossen bestimmt werden. Liegt eine niedrige Ähnlichkeit vor, kann der Zustand des Schaltkontakts 112 beispielsweise als geöffnet bestimmt werden. Das Vorliegen einer hohen oder niedrigen Ähnlichkeit kann beispielsweise durch einen Vergleich des Ähnlichkeitswertes mit einem Schwellwert bestimmt werden. Auch kann die Kombiniereinrichtung 275 ausgebildet sein, um eines oder beide der Überwachungssignale zu verwenden, um eine Impedanzmessung durchzuführen, sodass eine Impedanz des Schaltkontakts 112 bestimmt werden kann, oder eine Widerstandsmessung durchzuführen, sodass ein Widerstand des Schaltkontakts 112 bestimmt werden kann.

Gemäß einem Ausführungsbeispiel ist die Vorrichtung 140 ausgebildet, um ein Zustandssignal auszugeben, das den für den Schaltkontakt 112 bestimmten Zustand repräsentiert. Das Zustandssignal kann beispielsweise von einem zentralen Steuergerät, beispielsweise eines Fahrzeugs, weiterverarbeitet werden.

Gemäß einem Ausführungsbeispiel ist die Vorrichtung 140 ausgebildet, um ein Diagnosesignal 279 in einen der Anschlüsse 251, 254 oder in eine der Leitungen 252, 255 einzuspeisen. Beispielsweise kann die Vorrichtung 140 ausgebildet sein, um das Diagnosesignal 279 in einen der Überwachungspunkte 261, 264 einzuspeisen. Das Diagnosesignal 279 kann über eine der Überwachungsleitungen 262, 265 oder über eine zusätzliche Diagnoseleitung geführt werden. Das Diagnosesignal 279 kann ein Gleichsignal, beispielsweise eine Gleichspannung, oder ein Wechselsignal mit einer charakteristischen sich über die Zeit verändernden Signalform sein. Nach oder während des Einspeisens des Diagnosesignals 279 kann die Vorrichtung 140 ausgebildet sein, um über zumindest eine der Einleseeinrichtungen 271, 273 ein Überwachungssignal einzulesen und in der Kombiniereinrichtung 275 die beiden eingelesenen Überwachungssignale miteinander zu vergleichen oder eines der Überwachungssignale mit dem Diagnosesignal 279 zu vergleichen. Unter Verwendung des eingespeisten Diagnosesignals 279 kann ein der bereits bestimmte Zustand des Schaltkontakts 112 überprüft oder ein weiterer Zustand ermittelt werden.

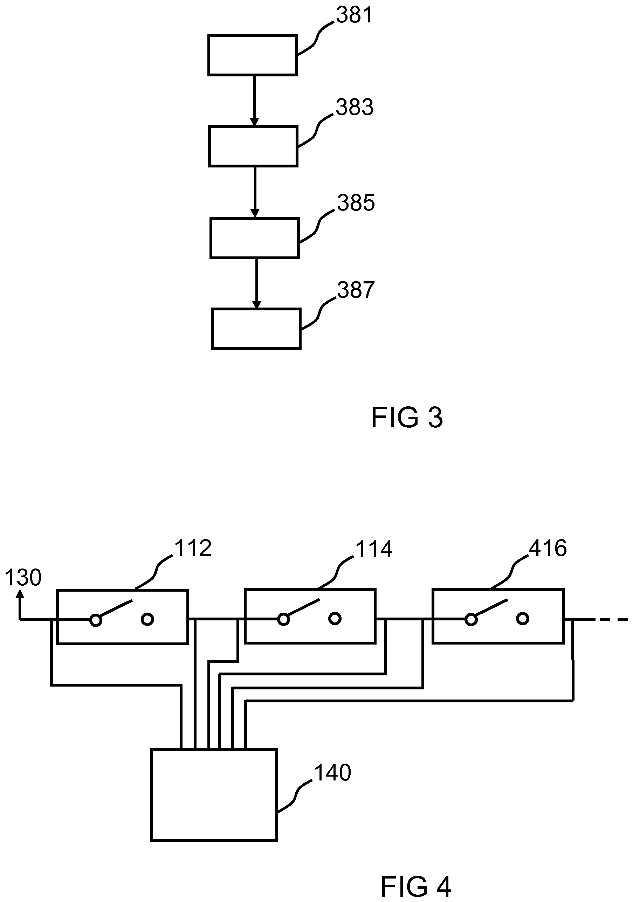

In entsprechender Form kann die Vorrichtung 140 eingesetzt werden, um eine Mehrzahl von Schaltkontakten zu überwachen, wie es beispielsweise nachfolgend in Fig. 4 gezeigt ist. Dabei kann jeder Schaltkontakt zwischen zwei Überwachungspunkten angeordnet sein oder es können auch zwei oder mehr Schaltkontakte zwischen zwei benachbarten Überwachungspunkten angeordnet sein. Auch kann zwischen zwei benachbarten Schaltkontakten nur ein Überwachungspunkt angeordnet sein, wobei das über diesen Überwachungspunkt eingelesene Signal zur Überwachung der beiden angrenzenden Schaltkontakte eingesetzt werden kann.

Die Leitungen 252, 255 sowie der Schaltkontakt 112 können galvanisch von den Überwachungsleitungen 262, 265 sowie einer Leitung zum Führen des Diagnosesignals 279 entkoppelt sein. Dies kann beispielsweise dadurch erreicht werden, dass die Überwachungssignale über an den Überwachungspunkten 261, 264 angeordnete Kondensatoren aus den Leitungen 252, 255 ausgekoppelt werden. Entsprechend kann das Diagnosesignal 279 über einen weiteren Kondensator in die Leitung 252 eingekoppelt werden.

Gemäß einem Ausführungsbeispiel sind die Leitungen 252, 255 und der Schaltkontakt 112 Teil einer Grünschleife. Dabei besteht eine galvanische Trennung zwischen der Grünschleife und einer Auswertung, die beispielsweise in der Vorrichtung 140 durchgeführt werden kann. Dadurch sind die Potenziale von Auswertung und Grünschleife voneinander getrennt. Es gibt somit keinen Massebezug. Wenn der Schaltkontakt 112 oder auch alle weiteren Schaltkontakte 112 der Grünschleife offen sind, besteht kein Massebezug. Die Überwachung kann dennoch dadurch erfolgen, dass der Wechselstromwiderstand einer Struktur, hier beispielsweise des Schaltkontakts 112, bestimmt wird.

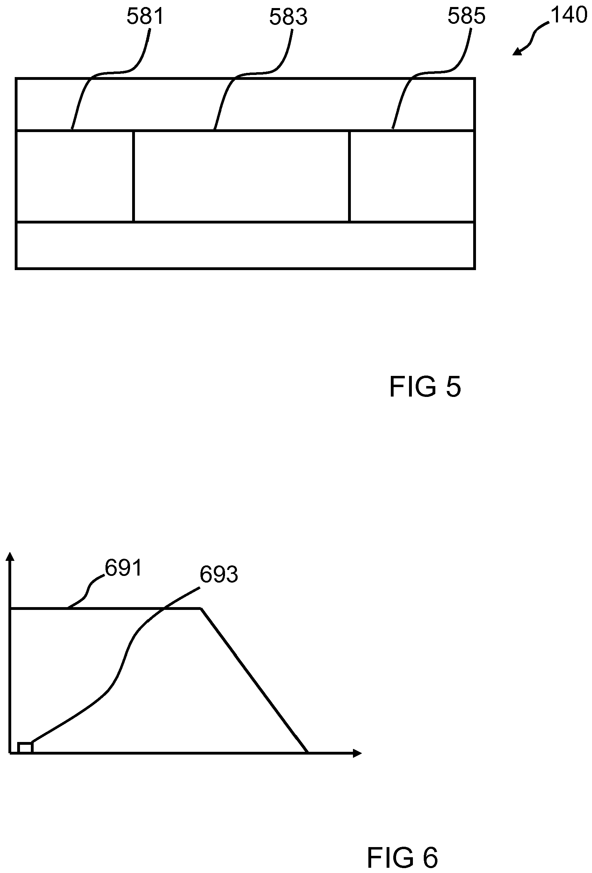

Gemäß einem Ausführungsbeispiel darf die Grünschleife oder das Signal der Grünschleife, typischerweise ein Gleichspannungssignal, nicht durch "Dritte" beeinflusst werden. Darum werden sehr geringe Signalleistungen verwendet, welche unter der EMV-Zulassung liegen, wie es nachfolgend anhand von Fig. 6 ausgeführt wird. Die Grünschleife wird von allen anderen Signalen galvanisch getrennt gehalten. Dies wird z. B. durch einen Kondensator erreicht. Das Wechselspannungssignal in Form des Diagnosesignals 279 wird über den Kondensator oder einen weiteren Kondensator auf die Grünschleife eingekoppelt und gleichspannungsfrei wieder über einen zweiten Kondensator ausgekoppelt. Das Problem einer masselosen Detektion, es können theoretisch alle Schalter offen sein bzw. ein Teil offen und ein Teil geschlossen sein, liegt darin, dass unbekannte Potenzialverhältnisse vorliegen. Davon abgeleitet wird das Diagnosesignal 279 so gewählt, dass der Wechselspannungswiderstand des Kabels, beispielsweise zwischen den einem Einspeispunkt des Diagnosesignals 279 und dem Überwachungspunkt 264, ausreicht, um eine notwendige Signalamplitude für die Auswerteschaltung 140 zu generieren. Die Grundidee dieses Ansatzes liegt dabei darin, einen Wechselspannungswiderstand einer unbekannten Struktur zu messen und mit geeigneten Verfahren mögliche Fehler davon abzuleiten. Je nach induktiven und kapazitiven Verhalten der Struktur kann das Diagnosesignal, insbesondere eine Frequenz des Diagnosesignals geeignet gewählt werden. Beispielsweise kann bei einer sehr geringen Induktivität oder Kapazität der Struktur ein Diagnosesignal mit einer hohen Frequenz gewählt werden. In herkömmlichen Verfahren wird mit Gleichspannungssignalen als Diagnosesignal gearbeitet bzw. es liegt keine galvanische Trennung vor. Das System ist dabei nicht nur auf Antriebe beschränkt, sondern kann ganz allgemein auch für z. B. Trittstufen, Bremseinheiten oder Verriegelungseinheiten oder -Systemen eingesetzt werden.

Fig. 3 zeigt ein Ablaufdiagramm eines Verfahrens zum Überwachen eines Schaltkontaktes gemäß einem Ausführungsbeispiel der vorliegenden Erfindung. Das Verfahren kann beispielsweise von Einrichtungen der in Fig. 2 gezeigten Vorrichtung umgesetzt werden.

In einem Schritt 381 wird ein erstes Signal von einem mit einem ersten Anschluss des Schaltkontakts verbundenen ersten Überwachungspunkt eingelesen. Basierend auf dem ersten Signal wird ein erstes Überwachungssignal generiert, beispielsweise durch Abtasten des ersten Signals.

In einem Schritt 383 wird ein zweites Signal von einem mit einem zweiten Anschluss des Schaltkontakts verbundenen zweiten Überwachungspunkt eingelesen. Basierend auf dem zweiten Signal wird ein zweites Überwachungssignal generiert, beispielsweise durch Abtasten des zweiten Signals.

In einem Schritt 385 werden das erste Überwachungssignal und das zweite Überwachungssignal kombiniert. Dadurch wird ein oder es werden mehrere unterschiedliche Parameter des Schaltkontakts betreffende Zustände des zumindest einen Schaltkontakts bestimmt.

In einem optionalen Schritt 387 kann ein Diagnosesignal als ein aktiv erzeugtes Störsignal an einen der Anschlüsse oder eine mit einem der Anschlüsse verbundene Leitung eingekoppelt werden. Anschließend können die Schritte 381, 383, 385 wiederholt ausgeführt werden.

Fig. 4 zeigt eine Schaltung für ein eine Mehrzahl von Türen umfassendes Türsystem gemäß einem Ausführungsbeispiel der vorliegenden Erfindung. Gezeigt sind beispielhaft drei Schaltkontakte 112, 114, 416 und eine Vorrichtung 140 zum Überwachen der Schaltkontakte 112, 114, 416, wie es bereits anhand der vorangegangenen Figuren beschrieben wurde.

Die Schaltkontakte 112, 114, 416 sind in Reihe geschaltet. Ein erster Anschluss des ersten Schaltkontakts 112 ist mit einer Energieversorgung 130, beispielsweise einer 144V Gleichspannungsquelle verbunden. Ein zweiter Anschluss des ersten Schaltkontakts 112 ist mit einem ersten Anschluss des ersten Schaltkontakts 114 verbunden. Ein zweiter Anschluss des zweiten Schaltkontakts 114 ist mit einem ersten Anschluss des dritten Schaltkontakts 416 verbunden.
Die Anordnung aus Schaltkontakten 112, 114, 416 und Energieversorgung 130 kann als eine sogenannte Grünschleife bezeichnet werden, über die der Schließzustand von Fahrzeugtüren überwacht werden kann. Über die Energieversorgung 130 und die Schaltkontakte 112, 114, 416 kann ein Schaltsignal für ein Steuergerät, beispielsweise eine sogenannte MDCU generiert werden.

Die Vorrichtung 140 ist über eine erste Überwachungsleitung mit dem ersten Anschluss des ersten Schaltkontakts 112, über eine zweite Überwachungsleitung mit dem zweiten Anschluss des ersten Schaltkontakts 112, über eine dritte Überwachungsleitung mit dem ersten Anschluss des zweiten Schaltkontakts 114, über eine vierte Überwachungsleitung mit dem zweiten Anschluss des zweiten Schaltkontakts 114, über eine fünfte Überwachungsleitung mit dem ersten Anschluss des dritten Schaltkontakts 416 und über eine sechste Überwachungsleitung mit dem zweiten Anschluss des dritten Schaltkontakts 416 verbunden. Zumindest eine der Überwachungsleitungen kann ausgebildet sein, um ein Diagnosesignal von der Vorrichtung 140 in einen der Anschlüsse der Schaltkontakte 112, 114, 416 einzuspeisen. Alternativ kann zumindest eine zusätzliche Leitung zum Führen zumindest eines Diagnosesignals vorgesehen sein.

Der zweite Anschluss des dritten Schaltkontakts 416 kann beispielsweise mit einem ersten Anschluss eines weitern Schaltkontakts, mit einem Anschluss eines Sicherheitsschützes oder mit einem Anschluss einer Auswerteeinrichtung verbunden sein, die ausgebildet ist, um beispielsweise durch eine Strommessung oder Spannungsmessung zu detektieren, ob eine durchgehende Verbindung zu der Energieversorgung 130 besteht, woraus geschlossen werden kann, dass alle Schaltkontakte 112, 114, 416 geschlossen sind.

In den mit den Anschlüssen der Schaltkontakte 112, 114, 416 verbundenen elektrischen Leitungen können beispielsweise aufgrund von Störfeldern Störsignale auftreten. Die Störsignale können über die Überwachungsleitungen erfasst und zur Überwachung der Schaltkontakte 112, 114, 416 eingesetzt werden. Dazu können beispielsweise über zwei verschiedene Überwachungsleitungen erfasste Störsignale, oder davon abgeleitete Überwachungssignale, bezüglich ihrer Form, ihres zeitlichen Versatzes oder ihres zeitlichen Versatzes zwischen Strom und Spannung ausgewertet werden.

Dadurch kann eine elektronische Schalterzustandsüberwachung oder eine elektronische Schaltkontakt-Überwachung realisiert werden. Als Grundlage dient dabei das sogenannte Superheterodyn Prinzip der Signalüberlagerungstheorie. Dabei werden die Effekte zunutze gemacht, dass es kein störungsfreies DC-Signal, das in diesem Ausführungsbeispiel von der Energieversorgung 130 durch die Schaltkontakte 112, 114, 416 geleitet wird, gibt und dass jedes DC-Signal auch mit Störungen überlagert ist (AC Signal).

Als Störquellen können beispielsweise im Rahmen der elektromagnetischen Verträglichkeit (EMV) betrachtete elektromagnetische Felder, Mobilfunkstrahlen beispielsweise des GSM-Standard, Schaltvorgänge oder allgemeines Rauschen dienen.

Es darf davon ausgegangen werden, dass die Störung (ganz allgemein betrachtet) über die zu betrachtende Struktur konstant bleibt. Dies bedeutet, dass unter der Voraussetzung das der Schalter geschlossen ist, die Störungen am Eingang des Schalters auch am Ausgang des Schalters vorhanden sind.

Zur Erhöhung der Detektionswahrscheinlichkeit der Schalterstellung der Schaltkontakte 112, 114, 416 kann zusätzlich ein zweites Störsignal, auch als Diagnosesignal bezeichnet, aktiv ins System eingebracht werden, welches ebenfalls bei Schalterstellung geschlossen der Schaltkontakte 112, 114, 416 sowohl am Eingang als auch am Ausgang, also den beiden Anschlüssen eines der Schaltkontakte 112, 114, 416 oder einer Serienschaltung aus mehreren oder allen der Schaltkontakte 112, 114, 416 messbar ist.

Die Vorrichtung kann die Schaltkontakte 112, 114, 416 beispielsweise auf Impedanz und Leitfähigkeit überprüfen, oder die Impedanz und Leitfähigkeit betreffende Werte ermitteln. Gemäß einem Ausführungsbeispiel ist die Vorrichtung 140 als ein digitaler Signal Controller ausgeführt. Somit ist eine unabhängige Analyse auf Impedanz und Leitfähigkeit einer Leiterschleife mittels digitalen Signal Controller möglich.

Gemäß einem Ausführungsbeispiel werden die Eingänge der Vorrichtung 140 abgetastet (gesampled) und auf Ähnlichkeit verglichen. Dazu kann z. B. eine Kreuzkorrelation oder Fourier-Transformation durchgeführt werden. Ist die Ähnlichkeit der abgetasteten Signale sehr hoch, woraus zu schließen ist, dass der betrachtete Schaltkontakt 112, 114, 416, auch Schalter genannt, geschlossen ist, wird mittels Beaufschlagung von einem digital generierten Störsignal, auch als Diagnosesignal bezeichnet, an einer oder an beiden Leitungen, die mit den Anschlüssen des betrachteten Schaltkontakts 112, 114, 416 verbunden sind, versucht eine Differenz zu schaffen. Bleibt die Ähnlichkeit der abgetasteten Werte der abgetasteten Signale in gewissem Masse gleich, ist der betrachtete Schaltkontakt 112, 114, 416 eindeutig geschlossen. Die Vorrichtung 140 kann in diesem Fall ausgebildet sein, ein entsprechendes Zustandssignal auszugeben, das den Zustand des betrachteten Schaltkontakts 112, 114, 416 anzeigt.

Gemäß einem Ausführungsbeispiel kann die Vorrichtung 140 folgende mögliche Messergebnisse bereitstellen. Zum einen kann der Schaltzustand am Schalter 112, 114, 416 und der Zustand der Leitungen zwischen den Schaltern 112, 114, 416 ermittelt werden. Ferner kann der Widerstand des Schalters 112, 114, 416 z. B. zur Ermittlung von Verschleiß oder bei Steckverbindung zum Auffinden von Kontaktfehlern oder Kabelbrüchen ermittelt werden. Ferner können Leckströme oder Übergangswiderstände zu anderen galvanischen Potenzialen, beispielsweise durch Messung der galvanischen Trennung zu z. B. einer Fahrzeug-Karosserie, ermittelt werden. Als Messergebnis kann ein komplexer Zeiger eines Widerstandes ermittelt werden. Der komplexe Zeiger des Widerstands kann verwendet werden, um zu erkennen, ob die Strecke zwischen zwei relevanten Überwachungspunkten der Signale, kapazitiv oder induktiv ist. Dies ermöglicht eine Erkennung, ob ein Sicherheitsschütz am Ende der Leitung in Ordnung ist. Ferner ist eine Auswertung der allgemein auftretenden Störfelder in der durch die Schaltkontakte 112, 114, 416 geführten Schleife möglich.

Fig. 5 zeigt ein Blockdiagramm einer Vorrichtung 140 zur Überwachung zumindest eines Schaltkontakts gemäß einem Ausführungsbeispiel der vorliegenden Erfindung. Die Vorrichtung 140 weist eingangseitig einen Eingangsfilter 581, beispielsweise einen Bandpass, ein Mikroprozessor 583 zur Bewertung der Signaldifferenzen und ausgangsseitig einen Ausgangsfilter 585 für ein aktives Störsignal auf.

Der Eingangsfilter 581 ist ausgebildet, um beispielsweise von geeigneten Überwachungspunkten an zumindest einem Schaltkontakt eingelesene Signale einer Eingangsfilterung zu unterziehen. Der Mikroprozessor 583 ist ausgebildet, um die gefilterten Signale zu kombinieren oder zu vergleichen. Der Ausgangsfilter 585 ist ausgebildet, um ein zur Einspeisung zu dem zumindest einen Schaltkontakt vorgesehenes Diagnosesignal in Form des aktiven Störsignals einer Ausgangsfilterung zu unterziehen.

Eine solche Vorrichtung 140 ist als Standalone Variante, also als eigenständiges Gerät, oder als voll in einem weiteren Steuergerät integrierte Variante realisierbar.

Fig. 6 zeigt eine Darstellung von EMV-Zulasssungsgrenzen gemäß einem Ausführungsbeispiel der vorliegenden Erfindung. Gezeigt ist ein Diagramm, bei dem auf der Abszisse die Frequenz in Hertz und auf der Ordinate die Feldstärke in Volt pro Meter aufgetragen ist. Eingezeichnet ist eine Kennlinie 691 die eine EMV-Grenze darstellt unterhalb derer Produkte voll funktionsfähig sein müssen. Zusätzlich ist eine Kennlinie 693 eingezeichnet, die eine EMV-Grenze der elektronischen Schaltkontakt-Überwachung zeigt, die beispielsweise durch eine beschriebe Vorrichtung zum Überwachen zumindest eines Schaltkontakts realisiert sein kann.

Durch die in Fig. 6 gezeigten EMV-Zulassungsgrenzen ist eine volle EMV-Tauglichkeit, sowohl die Einstrahlung als auch die Abstrahlung betreffend gegeben. Ferner ist eine minimale Betriebsleistung und somit eine Lage unterhalb der EMV Zulassungsgrenzen gegeben.

Der beschriebene Ansatz ermöglicht den Einsatz von Standardschaltern in einer Überwachungsschleife, beispielsweise einer sogenannten Grünschleife.

Solche Schalter ermöglichen bei Bedarf einen geringen Betätigungsweg von beispielsweise unter 4,9mm, eine hohe Betätigungsgeschwindigkeit von beispielsweise über 1m/s, eine hohe Betätigungskraft von beispielsweise über 3N und eine Rückstellkraft von beispielsweise weniger als 0,2N.

Dadurch können Ausfälle der Schalter aufgrund zu hoher Betätigungsgeschwindigkeiten vermieden werden. Auch sind geringe Betätigungswege realisierbar und es ist keine exakte Schaltereinstellung erforderlich. Zusätzlich können der Platzbedarf sowie die Kosten gering gehalten werden. Ferner kann die Spezifikation einer solchen Schaltung einfach gehalten werden, wodurch neue Entwicklungen, beispielsweise für den Einsatz einer Magnetbremse, unaufwendig gestaltet werden können.

Die beschriebenen Ausführungsbeispiele sind nur beispielhaft gewählt und können miteinander kombiniert werden.

### Bezugszeichenliste

- 100: Fahrzeug
- 102: Tür
- 104: Tür
- 112: Schaltkontakt
- 114: Schaltkontakt
- 130: Energieversorgung
- 132: Schütz
- 140: Vorrichtung zum Überwachen
- 251: erster Anschluss
- 252: erste Leitung
- 254: zweiter Anschluss
- 256: zweite Leitung
- 261: erster Überwachungspunkt
- 262: erste Überwachungsleitung
- 264: zweiter Überwachungspunkt
- 265: zweite Überwachungsleitung
- 271: Einleseeinrichtung
- 273: Einleseeinrichtung
- 275: Kombiniereinrichtung
- 278: Zustandssignal
- 279: Diagnosesignal
- 416: Schaltkontakt
- 581: Eingangsfilter
- 583: Mikroprozessor
- 585: Ausgangsfilter
- 691: Kennlinie
- 693: Kennlinie

## Patentansprüche

1. Verfahren zum Überwachen zumindest eines elektronischen Schaltkontakts (112, 114; 416) für ein Fahrzeug (100), wobei der Schaltkontakt (112, 114; 416) einen ersten Anschluss (251) für eine erste elektrische Leitung (252) und einen zweiten Anschluss (254) für eine zweite elektrische Leitung (255) aufweist, wobei der Schaltkontakt (112, 114; 416) als ein Schalter ausgeführt ist, durch den der erste Anschluss (251) und der zweite Anschluss (254) je nach Schaltzustand des Schaltkontakts (112, 114; 416) entweder elektrisch leitend miteinander verbunden sind oder voneinander elektrisch isoliert sind, wobei das Verfahren die folgenden Schritte umfasst:
Einlesen (381) eines ersten Signals von einem mit dem ersten Anschluss (251) verbundenen ersten Überwachungspunkt (261), um ein erstes Überwachungssignal zu erhalten;
Einlesen (383) eines zweiten Signals von einem mit dem zweiten Anschluss (254) verbundenen zweiten Überwachungspunkt (264), um ein zweites Überwachungssignal zu erhalten; und
Kombinieren (385) des ersten Überwachungssignals und des zweiten Überwachungssignals, um zumindest einen Zustand des zumindest einen Schaltkontakts (112, 114; 416) zu bestimmen,
**dadurch gekennzeichnet, dass**
im Schritt des Kombinierens (385) die Überwachungssignale miteinander verglichen werden, um Störsignale, die in den Überwachungssignalen abgebildet sind, zur Bestimmung des Zustands zu verwenden, wobei die Störsignale aufgrund von Störfeldern auftreten.

2. Verfahren gemäß Anspruch 1, bei dem im Schritt des Kombinierens (385) das erste Überwachungssignal und das zweite Überwachungssignal auf Ähnlichkeit untersucht werden, um den zumindest einen Zustand des zumindest einen Schaltkontakts (112, 114; 416) zu bestimmen.

3. Verfahren gemäß einem der vorangegangenen Ansprüche, bei dem im Schritt des Einlesens (381) des ersten Signals, das erste Signal von einem ersten Kontakt des ersten Überwachungspunkts (261) eingelesen wird, wobei ein zweiter Kontakt des ersten Überwachungspunkts (261) mit dem ersten Anschluss (251) verbunden ist und der erste und der zweite Kontakt des ersten Überwachungspunkts (261) galvanisch voneinander getrennt sind, und bei dem im Schritt des Einlesens (385) des zweiten Signals das zweite Signal von einem ersten Kontakt des zweiten Überwachungspunkts (264) eingelesen wird, wobei ein zweiter Kontakt des zweiten Überwachungspunkts (264) mit dem zweiten Anschluss (254) verbunden ist und der erste und der zweite Kontakt des zweiten Überwachungspunkts (264) galvanisch voneinander getrennt sind.

4. Verfahren gemäß einem der vorangegangenen Ansprüche, mit einem Schritt des Anlegens (387) eines Diagnosesignals (279) an den ersten Anschluss (251) und/oder den zweiten Anschluss (254) abhängig von dem im Schritt des Kombinierens (385) bestimmten zumindest einen Zustand des Schaltkontakts (112, 114; 416), wobei die Schritte des Einlesens (381, 383) und Kombinierens (385) ansprechend auf den Schritt des Anlegens (387) erneut durchgeführt werden.

5. Verfahren gemäß einem der vorangegangenen Ansprüche, bei dem im Schritt des Kombinierens (385) als der zumindest eine Zustand ein Schaltzustand des zumindest einen Schaltkontakts (112, 114; 416) bestimmt wird.

6. Verfahren gemäß einem der vorangegangenen Ansprüche, bei dem im Schritt des Kombinierens (385) als der zumindest eine Zustand ein elektrischer Widerstand des Schaltkontakts (112, 114; 416) und/oder eine Impedanz des Schaltkontakts (112, 114; 416) und/oder ein elektrischer Widerstand zwischen einem galvanischen Potenzial des Schaltkontakts (112, 114; 416) und einem weiteren galvanischen Potenzial bestimmt wird.

7. Verfahren gemäß einem der vorangegangenen Ansprüche, bei dem im Schritt des Kombinierens (385) als der zumindest eine Zustand eine Charakteristik des an dem ersten Anschluss oder dem zweiten Anschluss anliegenden Störsignals bestimmt wird.

8. Verfahren gemäß einem der vorangegangenen Ansprüche, mit einem Schritt des Einlesens eines dritten Signals von einem dritten Überwachungspunkt, wobei der dritte Überwachungspunkt mit einem Anschluss eines in Reihe mit dem Schaltkontakt (112, 114; 416) geschalteten weiteren Schaltkontakts (112, 114; 416) verbunden ist, um ein drittes Überwachungssignal zu erhalten, und bei dem im Schritt des Kombinierens das dritte Überwachungssignal und entweder das erste Überwachungssignal oder das zweite Überwachungssignal oder ein weiteres Überwachungssignal kombiniert werden, um zumindest einen Zustand des weiteren Schaltkontakts (112, 114; 416) zu bestimmen.

9. Vorrichtung (140) zum Überwachen zumindest eines elektronischen Schaltkontakts (112, 114; 416) für ein Fahrzeug (100), wobei der Schaltkontakt (112, 114; 416) einen ersten Anschluss (251) für eine erste elektrische Leitung (252) und einen zweiten Anschluss (254) für eine zweite elektrische Leitung (255) aufweist, wobei der Schaltkontakt (112, 114; 416) als ein Schalter ausgeführt ist, durch den der erste Anschluss (251) und der zweite Anschluss (254) je nach Schaltzustand des Schaltkontakts (112, 114; 416) entweder elektrisch leitend miteinander verbunden sind oder voneinander elektrisch isoliert sind, wobei die Vorrichtung die folgenden Merkmale aufweist:
eine erste Einleseeinrichtung (271) zum Einlesen eines ersten Signals von einem mit dem ersten Anschluss (251) verbundenen ersten Überwachungspunkt (261), um ein erstes Überwachungssignal zu erhalten;
eine zweite Einleseeinrichtung (273) zum Einlesen eines zweiten Signals von einem mit dem zweiten Anschluss (254) verbundenen zweiten Überwachungspunkt (264), um ein zweites Überwachungssignal zu erhalten; und
eine Kombiniereinrichtung (275) zum Kombinieren des ersten Überwachungssignals und des zweiten Überwachungssignals, um zumindest einen Zustand des Schaltkontakts (112, 114; 416) zu bestimmen,
**dadurch gekennzeichnet, dass**
die Kombiniereinrichtung (275) ausgebildet ist, um die Überwachungssignale miteinander zu vergleichen, um Störsignale, die in den Überwachungssignalen abgebildet sind, zur Bestimmung des Zustands zu verwenden, wobei die Störsignale aufgrund von Störfeldern auftreten.

10. Schaltung für ein eine Mehrzahl von Elementen (102, 104) umfassendes System für ein Fahrzeug (100), wobei die Schaltung die folgende Merkmale aufweist:
eine Reihenschaltung aus einer Mehrzahl von elektronischen Schaltkontakten (112, 114; 416), wobei je ein Schaltkontakt (112, 114; 416) einem der Elemente (102, 104) zugeordnet ist, und jeder der Schaltkontakte (112, 114; 416) eine Koppelschnittstelle zu einem dem Schaltkontakt (112, 114; 416) zugeordneten Element (102, 104) aufweist, um einen Zustand des zugeordneten Elements (102, 104) durch einen Schaltzustand des Schaltkontakts (112, 114; 416) abzubilden;
eine Mehrzahl von Überwachungspunkten (261, 264), die in der Reihenschaltung angeordnet sind, wobei jedem Anschluss (251, 254) der Schaltkontakte (112, 114; 416) ein Überwachungspunkt (261, 264) zugeordnet ist; und
eine Vorrichtung (140) zum Überwachen der Mehrzahl von Schaltkontakten (261, 264), wobei die Vorrichtung (140) eine der Mehrzahl von Überwachungspunkten (261, 264) entsprechende Anzahl von Einleseeinrichtungen (271, 273) aufweist, die je mit einem der Überwachungspunkte (261, 264) verbunden und ausgebildet sind, um je ein Signal von einem der Überwachungspunkte (261, 264) einzulesen, um pro Überwachungspunkt (261, 264) ein Überwachungssignal zu erhalten, und wobei die Vorrichtung (140) eine Kombiniereinrichtung (275) aufweist, die ausgebildet ist, um die Überwachungssignale zu kombinieren, um zumindest einen Zustand eines jeden der Schaltkontakte (112, 114; 416) zu bestimmen,
**dadurch gekennzeichnet, dass** ein erstes Ende der Reihenschaltung als eine Schnittstelle zu einer Energieversorgung (130) ausgeführt ist und die Reihenschaltung an einem dem ersten Ende gegenüberliegenden zweiten Ende einen elektromagnetischen Schalter (132) aufweist und wobei die Schaltung einen weiteren Überwachungspunkt der einem Anschluss des elektromagnetischen Schalters zugeordnet ist und eine mit dem weiteren Überwachungspunkt verbundene weitere Einleseeinrichtung aufweist, die ausgebildet ist, um ein Signal von dem weiteren Überwachungspunkt einzulesen, um ein weiteres Überwachungssignal zu erhalten, und wobei die Kombiniereinrichtung (275) ausgebildet ist, um unter Verwendung des weiteren Überwachungssignal als zumindest einen Zustand des elektromagnetischen Schalters (132) ein kapazitives oder induktives Verhalten des in der Reihenschaltung angeordneten elektromagnetischen Schalters (132) zu bestimmen,
und/oder
die Kombiniereinrichtung (275) ausgebildet ist, um die Überwachungssignale miteinander zu vergleichen, um Störsignale, die in den Überwachungssignalen abgebildet sind, zur Bestimmung des Zustands zu verwenden, wobei die Störsignale aufgrund von Störfeldern auftreten.

## Claims

1. Method for monitoring at least one electronic switching contact (112, 114; 416) for a vehicle (100), wherein the switching contact (112, 114; 416) comprises a first connection terminal (251) for a first electrical line (252) and a second connection terminal (254) for a second electrical line (255), wherein the switching contact (112, 114; 416) is in the form of a switch by means of which, depending on the switching condition of the switching contact (112, 114; 416) the first connection terminal (251) and the second connection terminal (254) are either electrically connected to one another or electrically isolated from one another, such that the said method comprises the following steps:
reading (381) of a first signal from a first monitoring point (261) connected to the first connection terminal (251) in order to obtain a first monitoring signal;
reading (383) of a second signal from a second monitoring point (264) connected to the second connection terminal (254) in order to obtain a second monitoring signal; and
combining (385) the first monitoring signal and the second monitoring signal in order to determine at least a condition of the at least one switching contact (112, 114; 416),
**characterised in that**
in the combining step (385) the monitoring signals are compared with one another in order to make use of interference signals reflected in the monitoring signals for the determination of the condition, the said interference signals occurring due to interference fields.

2. Method according to Claim 1, wherein in the combining step (385) the first monitoring signal and the second monitoring signal are examined for similarity in order to determine the at least one condition of the at least one switching contact (112, 114; 416),

3. Method according to either of the preceding claims, wherein, in the reading step (381) of the first signal, the said first signal is read from a first contact of the first monitoring point (261), whereas a second contact of the first monitoring point (281) is connected to the first connection terminal (251) and the said first and second contacts of the first monitoring point (261) are galvanically separated from one another, and wherein, in the reading step (385) of the second signal, the said second signal is read from a first contact of the second monitoring point (264), whereas a second contact of the second monitoring point (264) is connected to the second connection terminal (254), and the said first and second contacts of the second monitoring point (264) are galvanically separated from one another.

4. Method according to any of the preceding claims, with a step of applying (387) a diagnosis signal (279) at the first connection terminal (251) and/or the second connection terminal (254), depending on the at least one condition of the switching contact (112, 114; 416) determined in the combining step (385), wherein the reading steps (381, 383) and the combining step (385) are carried out again in response to the application step (387).

5. Method according to any of the preceding claims, wherein in the combination step (385), as the at least one condition a switching condition of the at least one switching contact (112, 114; 416) is determined.

6. Method according to any of the preceding claims, wherein in the combination step (385), as the at least one condition an electrical resistance of the switching contact (112, 114; 416) and/or an impedance of the switching contact (112, 114; 416) and/or an electrical resistance between a galvanic potential of the switching contact (112, 114; 416) and a further galvanic potential is determined.

7. Method according to any of the preceding claims, wherein in the combination step (385), as the at least one condition a characteristic of the interference signal applied at the first connection or at the second connection is determined.

8. Method according to any of the preceding claims, with a step of reading a third signal from a third monitoring point, such that the third monitoring point is connected to a connection terminal of a further switching contact (112, 114; 416) connected in series with the switching contact (112, 114; 416), in order to obtain a third monitoring signal, and wherein, in the combining step, the said third monitoring signal and either the first monitoring signal or the second monitoring signal or a further monitoring signal are combined, in order determine at least one condition of the further switching contact (112, 114; 416).

9. Device (140) for monitoring an electronic switching contact (112, 114; 416) for a vehicle (100), wherein the said switching contact (112, 114; 416) comprises a first connection terminal (251) for a first electric line (252) and a second connection terminal (254) for a second electric line (255), wherein the switching contact (112, 114; 416) is in the form of a switch by means of which, depending on the switching condition of the switching contact (112, 114; 416), the first connection terminal (251) and the second connection terminal (254) are either electrically connected to one another or electrically isolated from one another, such that the device has the following features:
a first reading device (271) for reading a first signal from a first monitoring point (261) connected to the first connection terminal (251), in order to obtain a first monitoring signal;
a second reading device (273) for reading a second signal from a second monitoring point (264) connected to the second connection terminal (251), in order to obtain a second monitoring signal; and
a combining device (275) for combining the first monitoring signal and the second monitoring signal, in order determine at least one condition of the switching contact (112, 114; 416),
**characterised in that**
the combining device (275) is designed to compare the monitoring signals with one another in order to make use of interference signals reflected in the monitoring signals for determining the condition, the said interference signals occurring due to interference fields.

10. Circuit for a system for a vehicle (100), that contains a plurality of elements (102, 104), wherein the said circuit has the following features:
a plurality of monitoring points (261, 264) arranged in the series circuit, wherein with each connection terminal (251, 254) of the switching contact (112, 114; 416) there is associated a monitoring point (261, 264); and
a device (140) for monitoring the plurality of switching contacts (112, 114; 416), wherein the device (140) comprises la number of reading devices (271, 273) that corresponds to the plurality of monitoring points (261, 264), each of which is connected to one of the monitoring points (261, 264) and is designed in each case to read a signal from one of the monitoring points (261, 264) in order to obtain a monitoring signal from each monitoring point (261, 264), and wherein the device (140) comprises a combining device (275) designed to combine the monitoring signals in order to determine at least one condition of each of the switching contacts (112, 114; 416),
**characterised in that**
a first end of the series circuit is designed as an interface with an energy supply (130) and at a second end opposite the first end, the series circuit comprises an electromagnetic switch (132), wherein the said switch is associated with a further monitoring point of the one connection terminal of the electromagnetic switch and comprises a further reading device connected to the said further monitoring point, which reading device is designed to read a signal from the further monitoring point in order obtain a further monitoring signal, and wherein the combining device (275) is designed, by making use of the said further monitoring signal as at least one condition of the electromagnetic switch (132), to determine a capacitative or inductive behaviour of the electromagnetic switch (132) arranged in the series circuit,
and/or
the combining device (275) is designed to compare the monitoring signals with one another, in order to make use of interference signals reflected in the monitoring signals for determining the condition, the said interference signals occurring due to interference fields.

## Revendications

1. Procédé de contrôle d'au moins un contact (112, 114; 416) électronique de commutation pour un véhicule (100), le contact (112, 114; 416) de commutation ayant une première borne (251) pour une première ligne (252) électrique et une deuxième borne (254) pour une deuxième ligne (255) électrique, le contact (112, 114; 416) de commutation étant réalisé sous la forme d'un interrupteur par lequel la première borne (251) et la deuxième borne (254) sont, suivant l'état de commutation du contact (112, 114; 416) de commutation, reliées entre elles d'une manière conductrice de l'électricité ou isolées l'une de l'autre électriquement, dans lequel le procédé comprend les stades suivants :
on lit (381) un premier signal, provenant d'un premier point (261) de contrôle relié à la première borne (251) pour obtenir un premier signal de contrôle;
on lit (383) un deuxième signal, provenant d'un deuxième point (264) de contrôle relié à la deuxième borne (254) pour obtenir un deuxième signal de contrôle et
on combine (385) le premier signal de contrôle et le deuxième signal de contrôle pour déterminer au moins un état du au moins un contact (112, 114; 416) de commutation,
**caractérisé en ce que**
dans le stade de la combinaison (385), on compare entre eux les signaux de contrôle pour utiliser, pour la détermination de l'état, des signaux perturbateurs, qui sont reproduits dans les signaux de contrôle, les signaux perturbateurs se produisant en raison de champs perturbateurs.

2. Procédé suivant la revendication 1, dans lequel, dans le stade de la combinaison (385), on étudie la similarité du premier signal de contrôle et du deuxième signal de contrôle pour déterminer au moins un état du au moins un contact (112, 114; 416) de commutation.

3. Procédé suivant l'une des revendications précédentes, dans lequel, dans le stade de la lecture (381) du premier signal, on lit le premier signal provenant d'un premier contact du premier point (261) de contrôle, dans lequel un deuxième contact du premier point (261) de contrôle est relié à la première borne (251) et le premier et le deuxième contacts du premier point (261) de contrôle sont séparés galvaniquement l'un de l'autre, et dans lequel, dans le stade de la lecture (385) du deuxième signal, on lit le deuxième signal provenant d'un premier contact du deuxième point (264) de contrôle, dans lequel un deuxième contact du deuxième point (264) de contrôle est relié à la deuxième borne (254) et le premier et le deuxième contacts du deuxième point (264) de contrôle sont séparés galvaniquement l'un de l'autre.

4. Procédé suivant l'une des revendications précédentes, comprenant un stade d'application (387) d'un signal (279) de diagnostic à la première borne (251) et/ou à la deuxième borne (254), en fonction du au moins un état du contact (112, 114; 416) de commutation déterminé au stade de la combinaison (385), dans lequel on effectue le stade de la lecture (381, 383) et de la combinaison (385) à nouveau, conformément au stade du diagnostic (387).

5. Procédé suivant l'une des revendications précédentes, dans lequel, dans le stade de la combinaison (385), on détermine, comme le au moins un état, un état de commutation du au moins un premier contact (112, 114; 416) de commutation.

6. Procédé suivant l'une des revendications précédentes, dans lequel, dans le stade de la combinaison (385), on détermine, comme le au moins un état, une résistance électrique du contact (112, 114; 416) de commutation et/ou une impédance du contact (112, 114; 416) de commutation et/ou une résistance électrique entre un potentiel galvanique du contact (112, 114; 416) de commutation et un autre potentiel galvanique.

7. Procédé suivant l'une des revendications précédentes, dans lequel, dans le stade de la combinaison (385), on détermine, comme le au moins un état, une caractéristique du signal perturbateur s'appliquant à la première borne ou à la deuxième borne.

8. Procédé suivant l'une des revendications précédentes, comprenant un stade de lecture d'un troisième signal provenant d'un troisième point de contrôle, dans lequel le troisième point de contrôle est relié à une borne d'un autre contact (112, 114; 416) de commutation, monté en série avec le contact (112, 114; 416) de commutation, pour obtenir un troisième signal de contrôle et dans lequel, dans le stade de la combinaison, on combine le troisième signal de contrôle et soit le premier signal de contrôle, soit le deuxième signal de contrôle, soit un autre signal de contrôle pour déterminer au moins un état de l'autre contact (112, 114; 416) de commutation.

9. Système (140) de contrôle d'au moins un contact (112, 114; 416) électronique de commutation pour un véhicule (100), dans lequel le contact (112, 114; 416) de commutation a une première borne (251) pour une première ligne (252) électrique et une deuxième borne (254) pour une deuxième ligne (255) électrique, le contact (112, 114; 416) de commutation étant réalisé sous la forme d'un interrupteur par lequel la première borne (251) et la deuxième borne (254) sont, suivant l'état de commutation du contact (112, 114; 416) de commutation, reliées entre elles d'une manière conductrice de l'électricité ou isolées l'une de l'autre électriquement, dans lequel le système a les caractéristiques suivantes :
un premier dispositif (271) de lecture pour lire un premier signal provenant d'un premier point (261) de contrôle relié à la première borne (251) pour obtenir un premier signal de contrôle;
un deuxième dispositif (273) de lecture pour lire un deuxième signal provenant d'un deuxième point (264) de contrôle relié à la deuxième borne (254) pour obtenir un deuxième signal de contrôle et
un dispositif (275) de combinaison pour combiner le premier signal de contrôle et le deuxième signal de contrôle pour déterminer au moins un état du contact (112, 114; 416) de commutation,
**caractérisé en ce que**
le dispositif (275) de combinaison est constitué pour comparer entre eux les signaux de contrôle, pour utiliser, pour la détermination de l'état, des signaux parasites, qui sont reproduits dans les signaux de contrôle, les signaux parasites se produisant en raison de champs parasites.

10. Circuit pour un système comprenant une pluralité d'éléments (102, 104) pour un véhicule (100), le circuit ayant les caractéristiques suivantes :
un circuit série, composé d'une pluralité de contacts (112, 114; 416) électroniques de commutation, chaque contact (112, 114; 416) de commutation étant affecté à l'un des éléments (102, 104) et chacun des contacts (112, 114; 416) de commutation a une interface de couplage à un élément (102, 104) affecté au contact (112, 114; 416) de commutation pour reproduire un état de l'élément (102, 104) affecté par un état de commutation du contact (112, 114; 416) de commutation;
une pluralité de points (261, 264) de contrôle, qui sont montés dans le circuit en série, un point (261, 264) de contrôle étant affecté à chaque borne (251, 254) des contacts (112, 114; 416) de commutation et
un système (140) de contrôle de la pluralité de contacts (261, 264) de commutation, le système (140) ayant un nombre correspondant à la pluralité de points (261, 264) de contrôle de dispositifs (271, 273) de lecture, qui sont reliés chacun à l'un des points (261, 264) de contrôle et qui sont constitués pour lire chacun un signal provenant de l'un des points (261, 264) de contrôle, afin d'obtenir un signal de contrôle par point (261, 264) de contrôle et dans lequel le système (140) a un dispositif (275) de combinaison constitué pour combiner les signaux de contrôle, afin de déterminer au moins un état de chacun des contacts (112, 114; 416) de commutation,
**caractérisé en ce qu'**une première extrémité du circuit en série est réalisée sous la forme d'une interface avec une alimentation (130) en énergie et le circuit en série a, à une seconde extrémité opposée à la première extrémité, un interrupteur (132) électromagnétique et dans lequel le circuit a un autre point de contrôle, qui est affecté à une borne de l'interrupteur électromagnétique et un autre dispositif de lecture relié à l'autre point de contrôle, qui est constitué pour lire un signal provenant de l'autre point de contrôle, afin d'obtenir un autre signal de contrôle et dans lequel le dispositif (275) de combinaison est constitué pour, en utilisant l'autre signal de contrôle, comme au moins un état, de l'interrupteur (132) électromagnétique, déterminer un comportement capacitif ou inductif de l'interrupteur (132) électromagnétique monté dans le circuit en série,
et/ou
le dispositif (275) de combinaison est constitué pour comparer entre eux les signaux de contrôle, pour utiliser, pour la détermination de l'état, des signaux parasites, qui sont reproduits dans les signaux de contrôle, les signaux parasites se produisant en raison de champs parasites.
